# EUROPEAN PATENT SPECIFICATION

(11) **EP 1 696 599 B1**
(45) Date of publication and mention of the grant of the patent: **28.07.2010**
(21) Application number: 05025830.0
(22) Date of filing: 25.11.2005
(51) Int. Cl.: H04L 7/02, H04L 7/00, H04L 7/033, G11C 7/10, G11C 11/4096, G06F 13/16

(54) **Source synchronous communication channel interface receive logic**
Empfangslogik einer Schnittstelle eines mit einer Quelle synchronen Kommunikationskanals
Logique de réception d'une interface de canal de transmission synchrone avec une source

(30) Priority: 24.02.2005 US 63968
(43) Date of publication of application: 30.08.2006
(73) Proprietor: Broadcom Corporation, Irvine, CA 92617 (US)
(72) Inventor: Jain, Sudhanshu, 95050 Santa Clara, CA (US)
(74) Representative: Jehle, Volker Armin

(56) References cited:
- US-A- 5 857 095
- US-A1- 2003 218 483
- US-A1- 2004 052 129
- US-B1- 6 509 762
- US-B1- 6 621 760
- GOGAERT S ET AL: "A skew tolerant CMOS level-based ATM data-recovery system without PLL topology" CUSTOM INTEGRATED CIRCUITS CONFERENCE, 1997., PROCEEDINGS OF THE IEEE 1997 SANTA CLARA, CA, USA 5-8 MAY 1997, NEW YORK, NY, USA,IEEE, US, 5 May 1997 (1997-05-05), pages 453-456, XP010235343 ISBN: 0-7803-3669-0

## Description

### BACKGROUND OF THE INVENTION

### Field of the Invention

The present invention relates to a network device in a data communications network and more particularly to a method of obtaining an optimal sampling of data obtained from an external source synchronous communication channel.

### Description of the Related Art

A data network may include one or more network devices, such as a Ethernet switching chip, each of which includes several modules that are used to process information that is transmitted through the device. Specifically, as data enters the device from multiple ports, it is forwarded to an ingress module where switching and other processing are performed on the data. Thereafter, data is transmitted to one or more destination ports through one or more units including a Memory Management Unit (MMU). The MMU provides access to one or more off-chip source synchronous memory devices, for example, an external Double Data Rate (DDR) memory. The network device typically generates a source synchronous clock that is provided with data during a write operation on the source synchronous memory device. The memory device then uses the clock to capture the data and perform the write operation. However, when the network device is performing a read operation from the memory device, the delay for data and clock from the memory device is indeterministic based on at least the trace lengths and process corner associated with the memory device. For example, if there is a fast process or slow process corner device, the delay from the memory device will vary. As such, the round trip delays for a read operation can vary greatly from chip-to-chip or board-to-board.

When a read operation is performed by the source synchronous memory device, the memory device returns data and clock. However, the clock phase from the source synchronous memory device can vary relative to the clock within the network device because the phases may shift. As is known, when the phases of the clock and data line up with each other, bit errors may occur and the network device cannot adequately sample data returned from the memory device.

Therefore, to obtain the least amount of error, a mechanism must be provided to sample the received data at a time when the data is most stable. Some source synchronous interfaces and some memory devices provide free running clocks. Current network devices typically sample the data multiple times to find out where the edges exist in relation to the internal clock in the network device. However, when there are no memory operations being performed by the source synchronous memory device, the received data is not changing. Hence, there are no edges/transitions for determining the optimal phase of the clock. Furthermore, even if memory operations are occurring, if the same data value is being continuously read, there will still be no transitions for determining the optimal phase of the clock.

To overcome the problems presented by source synchronous memory devices with free running clocks, some network devices use a first-in-first-out (FIFO) buffer to absorb difference between the memory controller clock in the network device and the clock generated by the source synchronous memory device. However, the use of the FIFO to absorb the differences between the clocks increases gate count which in turn increases circuit area. Use of a FIFO to realign clock phases also increases latency for received data.

US 6,509,762 describes a method and apparatus for capturing data read from a memory device that is aligned with respect to a clock strobe signal originating from the memory device, which has constraints with respect to a local clock signal supplied to the memory device. The apparatus includes a circuit for capturing the data read from the memory device relative to the clock strobe signal to produce captured read data, a circuit for latching the captured read data relative to a sample clock signal, and a circuit for measuring a phase difference between the sample clock signal and the clock strobe signal and adjusting a phase of the sample clock signal as a function of the phase difference.

According to the invention, there are provided a network device for determining an optimal sampling phase for source synchronous data as defined by independent claim 1, and a method for determining an optimal sampling phase for source synchronous data as defined by independent claim 4.

Further advantageous features of the invention are defined by the dependent subclaims.

Advantageously, the transmitter clock domain comprises means for transmitting the clock to a phase shift generator and for transmitting an output from the phase shift generator to a circuit which creates the data pattern.
Advantageously, the transmitter clock domain further comprises means for sampling the data with the output of the phase shift generator, wherein the data is sampled using edges of a clock outputted by the phase shift generator.
Advantageously, the transmitter clock domain further comprises means for aligning data sampled at the rising and falling edges of the clock outputted by the phase shift generator with the locally generated data pattern.
Advantageously, the transmitter clock domain comprises a flip-flop cell that is used in a divide-by-two operation on the clock and in sampling the data generated by the memory device.
Advantageously, the sampling means comprises means for sampling the locally generated data pattern multiple times with the plurality of phases to determine the optimal sampling phase for sampling the received data.
Advantageously, the memory clock domain further comprises means for providing the locally generated data pattern with a deterministic rate of periodic transitions.
Advantageously, at least one of the plurality of phases includes an offset from the core clock
Advantageously, the sampling means includes means for selecting one of the plurality of phases that provides sampling points that are farthest from the edges of the received data.
Advantageously, the step of creating comprises transmitting the clock to a phase shift generator and transmitting an output from the phase shift generator to a circuit which creates the locally generated data pattern.
Advantageously, the method further comprises the step of sampling the data with the output of the phase shift generator.
Advantageously, the method further comprises the step of aligning data sampled using edges of the output of the phase shift generator with the locally generated data pattern.
Advantageously, the step of sampling comprises the step of sampling the locally generated data pattern multiple times with the plurality of phases to determine the optimal sampling phase for sampling the received data.
Advantageously, the method further comprises the step of providing the locally generated data pattern with a deterministic rate of periodic transitions.
Advantageously, the step of sampling comprises the step of providing at least one of the plurality of phases with an offset from the core clock
Advantageously, the step of sampling comprises the step selecting one of the plurality of phases that provides sampling points that are farthest from the edges of the received data.

### BRIEF DESCRIPTION OF THE DRAWINGS

The accompanying drawings, which are included to provide a further understanding of the invention and are incorporated in and constitute a part of this specification, illustrate embodiments of the invention that together with the description serve to explain the principles of the invention, wherein:
Figure 1 illustrates a network device in which an embodiment of the present invention may be implemented;
Figure 2a illustrates how memory read data is sampled by the network device;
Figure 2b aligned memory clock and read data;
Figure 3 illustrates sampling phases generated by the network device using multiple quadrature phases; and
Figure 4 illustrates the steps in providing data for sampling from a memory clock domain to a network device clock domain.

### DETAILED DESCRIPTION OF PREFERRED EMBODIMENTS

Reference will now be made to the preferred embodiments of the present invention, examples of which are illustrated in the accompanying drawings.

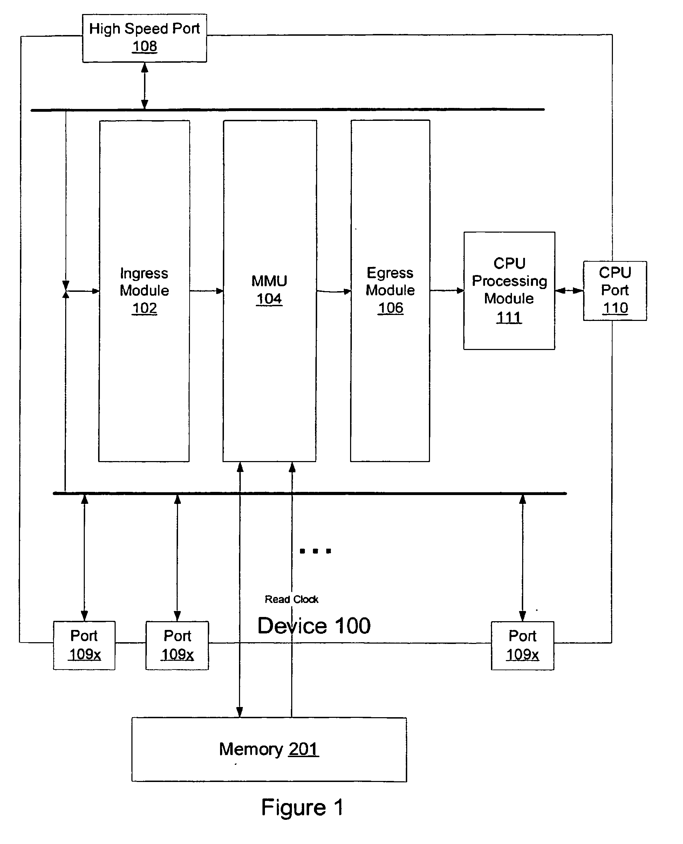

Figure 1 illustrates a network device, such as a switching chip, in which an embodiment the present invention may be implemented. Device 100 includes an ingress module 102, a MMU 104, and an egress module 106. Ingress module 102 is used for performing switching functionality on an incoming packet. The primary function of MMU 104 is to efficiently manage cell buffering and packet pointer resources in a predictable manner even under severe congestion scenarios. Egress module 106 is used for performing packet modification and transmitting the packet to an appropriate destination port.

Device 100 may also include one internal fabric high speed port, for example a HiGig port, 108, one or more external Ethernet ports 109a-109x, and a CPU port 110. High speed port 108 is used to interconnect various network devices in a system and thus form an internal switching fabric for transporting packets between external source ports and one or more external destination ports. As such, high speed port 108 is not externally visible outside of a system that includes multiple interconnected network devices. CPU port 110 is used to send and receive packets to and from external switching/routing control entities or CPUs. According to an embodiment of the invention, CPU port 110 may be considered as one of external Ethernet ports 109a-109x. Device 100 interfaces with external/off-chip CPUs through a CPU processing module 111, such as a CMIC, which interfaces with a PCI bus that connects device 100 to an external CPU.

Network traffic enters and exits device 100 through external Ethernet ports 109a-109x. Specifically, traffic in device 100 is routed from an external Ethernet source port to one or more unique destination Ethernet ports. In one embodiment of the invention, device 100 supports twelve physical Ethernet ports 109, each of which can operate in 10/100/1000 Mbps speed and one high speed port 108 which operates in either 10 Gbps or 12 Gbps speed.

In an embodiment of the invention, device 100 is built around a shared memory architecture, wherein MMU 104 provides access to one or more off-chip source synchronous memory devices, for example, an external Double Data Rate (DDR) memory device 201. In an embodiment of the invention, MMU 104 includes 4 DDR interfaces. During a write operation to device 201, network device 100 typically generates a source synchronous clock that is provided with data to the source synchronous memory device. Memory device 201 then uses the clock to capture the data and perform the write operation. However, when network device 100 is performing a read operation from memory device 201, the phase of the received clock and data is indeterministic and thus an optimal sampling phase must be derived.

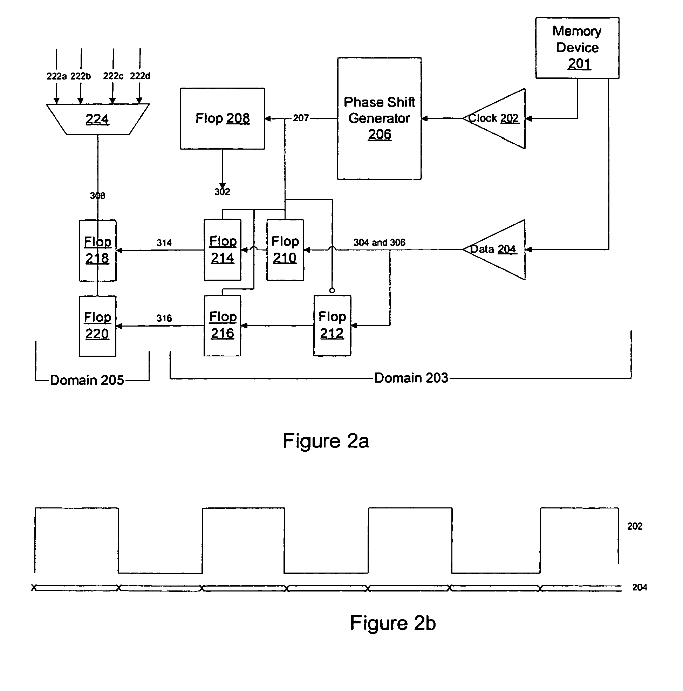

Figure 2a illustrates how memory read data is sampled by device 100 and timing is transferred from a clock domain 203 of the external memory to an internal clock domain 205 of device 100. As shown in figure 2, during a read operation in memory clock domain 203, memory device 201 generates a clock 202 and data 204 which is aligned as shown in figure 2b. This figure shows double data rate (DDR) data but the data could also be single data rate (SDR). However, the aligned clock 202 and data 204 do not provide an optimal sampling phase because clock edges do not occur when the data is most stable. Therefore, clock 202 is transmitted to a 90 degree phase shift generator 206, with offset control, which generates a 90 degree phase offset clock 207. Shift generator 206 may be a standard DLL or PLL generator. Clock 207 is then used to sample data 204, wherein clock 207 samples data 204 at the rising edge of clock 207 at flop 210 and samples data 204 at the falling edge of clock 207 at flop 212. Thereafter flops 214 and 216 are used to line up the data sampled at the rising and falling edges of the clock 207. Clock 207 is also transmitted to a divide-by-two circuit 208 which creates an alternating 1/0 data pattern that alternates every clock cycle. According to an embodiment of the invention, by using the same flip-flop cell in the divide-by-two operation as is used for the initial read data sample, the inventive system allows for better matching of delays and better determination of the optimal sampling phase. In an embodiment of the inventive system, memory 201 is not required to perform an operation in order for device 100 to obtain the needed transitions that are sampled to determine an optimal phase for sampling data. The sampled results are then synchronized back into main clock domain 205 and are then fed into the state machine to decide which quadrature phase should be used to sample data from memory clock domain 203.

In an embodiment of the invention, along with the rise and fall data transmitted from memory device 201, device 100 also obtains the alternating 1/0 data pattern generated by circuit 208, wherein the alternating data pattern is in line with the aligned rise and fall data from flops 214 and 216. Device 100 then uses phases 222a-222d to multiply sample the alternating 1/0 data pattern multiple times to determine the optimal sampling phase. Thereafter, in core clock domain 205, device 100 provides multiple quadrature phases 222a-222d of a core clock. Phase 222a has a 0 degree offset from the core clock, phase 222b has a 270 degree offset from the core clock, phase 222c has a 180 degree offset from the core clock and phase 222d has a 90 degree offset from the core clock. According to one embodiment of the invention, device 100 generates four phases 222a-222d of the core clock. However, as is known to those of ordinary skill in the art, device 100 may generate more than four phases for better resolution.

In an embodiment of the inventive system, during sampling, device 100 ignores data 204 returned from memory device 201. Device 100 only samples the alternate 1/0 data pattern from clock 202, wherein the 1/0 data pattern provides a transition in every cycle. Since device 100 samples the alternating 1/0 data pattern, memory 201 is not required to perform an operation in order for device 100 to obtain the needed transitions that are sampled to determine an optimal phase for sampling data. As such, the inventive system eliminates the drifts that occur between phases when a transition does not occur every cycle, thereby causing the phase to be off. By producing a transition every cycle, the inventive system enables device 100 to constantly re-correct in order to determine the location of the optimal sampling phase.

Sampling of the alternating data pattern provides an advantage over directly sampling of the received clock or data in that it enables better phase match with the delays data from flops 214 and 216 to provide the most optimal sampling phase. The process corner delay variations of the alternating data pattern match the process corner delay variation of the data from flops 214 and 216. As is known to those skilled in the art, the clock returned from memory 201 typically includes jitter that blurs the edges. As such when a sample is obtained from near the edge, the data pattern may sometimes be a zero or a one, which is a non-optimal point for sampling data. Therefore, according to an embodiment of the invention, device 100 selects the optimal sampling phase that will produce the fewest sampling error, that is, a sampling phase that is farthest away from the edges.

As mentioned above, device 100 operates without the need for any memory operations. As such, when device 100 is started, as long as a free running clock in memory 201 is executing, device 100 can determine the optimal sampling phase. Device 100 therefore relies only on the free running read strobe clock from external memory 210 and may run without a training sequence and remains locked even in the absence of memory operations. Since there is a transition every cycle, device 100 can realign every cycle, is insensitive to data patterns, and can tolerate infinite sequences of ones and zeros. Device 100 can also respond quickly to changes in phase of memory read strobe clocks since the sampled data has a guaranteed transition on every rising clock edge.

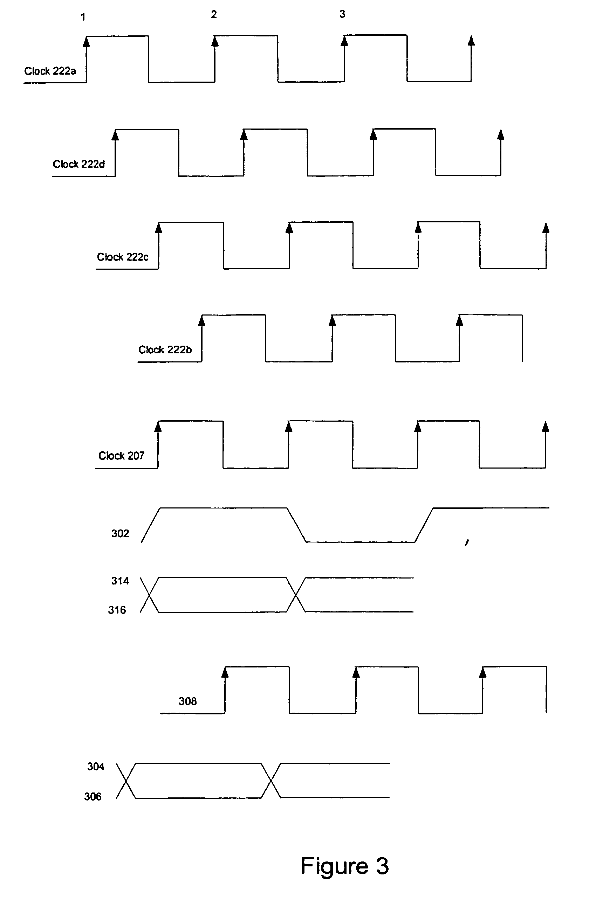

Figure 3 illustrates sampling phases generated by device 100 using phases 222a-222d. According to the inventive system, as illustrated in figure 3, the 90 degree shifted clock 207 was used to create an alternating 1/0 data pattern 302 which is then double-flop sampled with multiple 90 degree shifted quadrature phases 222a-222d. The sample clock which lands in the middle of the eye of the alternate 1/0 pattern is the used to sample all of the read data from the memory. Therefore, based on the illustrations of figure 3, clock phase 222a will be selected as the optimal sampling phase because that phase provides points that are farthest away from the edges of the clock. Since an embodiment of the inventive system uses the same flip-flop cell that is used for generating the alternate 1/0 pattern for sampling the read data from the memory, the phase of the alternate 1/0 pattern is virtually identical to the phase of the sampled rise and fall data 304 and 306. Therefore, the optimal clock phase 222a, as shown as 308, needed to sample the alternate 1/0 pattern will be the same as that needed to sample rise and fall data 314 and 316 at the output of flops 214 and 216.

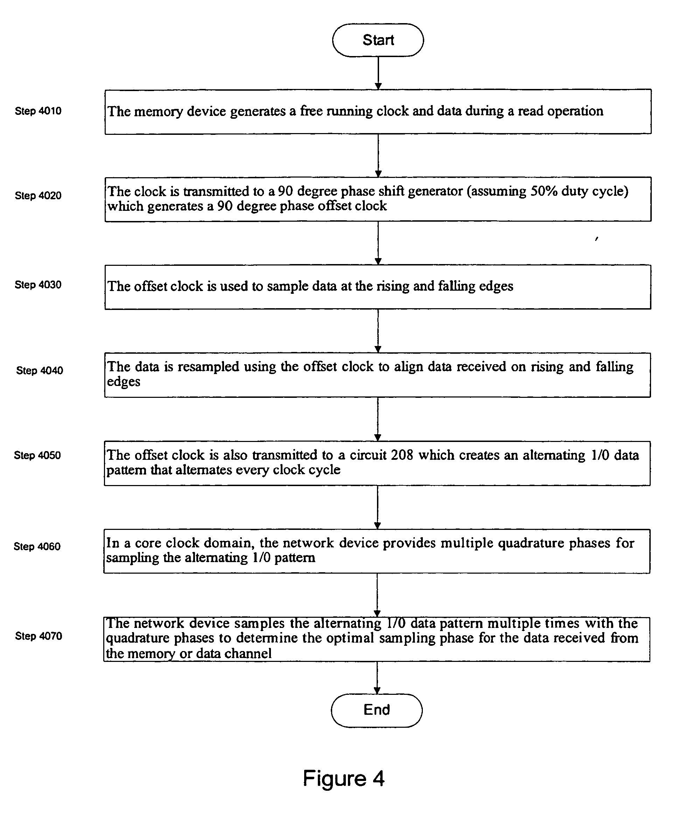

Figure 4 illustrates the steps implemented in transferring timing from a memory clock domain to a core clock domain in order to determine an optimal sampling phase. In Step 4010, during a read operation in memory clock domain 203, memory device 201 generates clock 202 and data 204. In Step 4020, clock 202 is then transmitted to 90 degree phase shift generator 206 which generates 90 degree phase offset clock 207. It should be noted that while the phase shift generator 206 in one embodiment of the invention is a 90 degree phase shift generator, a 90 degree phase shift generator is optional and other phase shift generators may be implemented in the present invention. In Step 4030, clock 207 is used to sample data at the rising and falling edges of clock 207. In Step 4040, the data sampled at the rising and falling edges of the clock 207 are lined up. In Step 4050, clock 207 is also transmitted to divide-by-two circuit 208 which creates an alternating 1/0 data pattern that alternates every clock cycle. In Step 4060, in core clock domain 205, device 100 provides multiple quadrature phases 222a-222d for sampling the alternating 1/0 pattern. In Step 4070, device 100 samples the alternating 1/0 data pattern multiple times with clocks 222a-222d to determine which of the quadrature phases is optimal for resampling the received data.

According to an embodiment, device 100 includes an algorithm for determine which quadrature clock 222a-222d to use in sampling data. The algorithm relies on comparing samples (voting) from clocks 222a-222d of the sampled values from the alternating 1/0 pattern to determine where the edges of the received data are located.

The foregoing description has been directed to specific embodiments of this invention. It will be apparent, however, that other variations and modifications may be made to the described embodiments, with the attainment of some or all of their advantages. Therefore, it is the object of the appended claims to cover all such variations and modifications as come within the scope of the invention.

## Claims

1. A network device (100) for determining an optimal sampling phase for source synchronous data (204) sent from an external device (201), the network device (100) comprising:
receiving means for receiving from a transmitting device, in a transmitter clock domain (203), an external device clock (202) and data (204) with a fixed phase relationship;
a phase shift generator (206) for phase shifting the external device clock (202);
**characterized by**
a divide-by-two circuit (208) for receiving the phase shifted external device clock (207) and for generating an alternating 1/0 signal pattern (302), which alternates every clock cycle;
means (210, 212) for sampling the data signal (304, 306) in the transmitter clock domain (203) using said phase shifted external device clock, and for aligning (214, 216) the sampled data with said alternating signal 1/0 pattern (302);
means for generating a plurality of phases (222a, 222b, 222c, 222d) of a core clock;
means for sampling the alternating 1/0 signal pattern (302) in a core clock domain (205) with the plurality of phases (222a, 222b, 222c, 222d);
means (224) for selecting the optimal sampling phase (308) for sampling the alternating 1/0 signal pattern (302); and
means for sampling the aligned data (314, 316) with the selected optimal sampling phase (308).

2. The network device (100) according to claim 1, wherein the transmitter clock domain further comprises means for sampling the data (204) with the output of the phase shift generator, wherein the data (204) is sampled using edges of a phase shifted external device clock (207) outputted by the phase shift generator.

3. The network device (100) according to claim 2, wherein the transmitter clock domain further comprises means for aligning data (204) sampled at the rising and falling edges of the phase shifted external device clock (207) outputted by the phase shift generator with the locally generated signal pattern (302).

4. A method for determining an optimal sampling phase for source synchronous data (204) sent from an external device (201), the method comprising the steps of:
receiving from a transmitting device, in a transmitter clock domain (203), external device clock (202) and data (204) with a fixed phase relationship;
phase shifting the external device clock (202, 206),
generating an alternating 1/0 signal pattern (302), which alternates every clock cycle, out of the phase shifted external device clock using a divide-by-two-circuit,
sampling the data signal (304, 306) in the transmitter clock domain (203) using said phase shifted external device clock, and aligning (214, 216) the sampled data with said alternating signal pattern (302);
generating a plurality of phases (222a, 222b, 222c, 222d) of a core clock;
sampling the alternating 1/0 signal pattern (302) in a core clock domain (205) with the plurality of phases (222a, 222b, 222c, 222d);
selecting the optimal sampling phase (308) for sampling the alternating 1/0 signal pattern (302); and
sampling the aligned data (314, 316) with the selected optimal sampling phase (308).

5. The method according to claim 4, wherein the step of creating comprises transmitting the external device clock (202) to a phase shift generator and transmitting an output from the phase shift generator to a circuit which creates the locally generated signal pattern (302).

6. The method according to claim 5, further comprising the step of sampling the data (204) with the output of the phase shift generator.

7. The method according to claim 6, further comprising the step of aligning data (204) sampled using edges of the output of the phase shift generator with the locally generated signal pattern (302).

## Patentansprüche

1. Netzwerkvorrichtung (100) zum Ermitteln einer optimalen Abtastphase für mit einer Quelle synchrone Daten (204), die von einer externen Vorrichtung (201) gesendet werden, wobei die Netzwerkvorrichtung (100) Folgendes umfasst:
eine Empfangseinrichtung zum Empfangen, von einer Sendevorrichtung, in einer Sendertaktdomäne (203) eines Taktes (202) der externen Vorrichtung und von Daten (204) mit einer festen Phasenbeziehung;
einen Phasenverschiebungsgenerator (206) zum Phasenverschieben des externen Vorrichtungstaktes (202);
**gekennzeichnet durch**
eine Halbierschaltung (208) zum Empfangen des phasenverschobenen externen Vorrichtungstaktes (207) und zum Erzeugen eines alternierenden 1/0-Signalmusters (302), das bei jedem Taktzyklus alterniert;
eine Einrichtung (210, 212) zum Abtasten des Datensignals (304, 306) in der Sendertaktdomäne (203) unter Verwendung des phasenverschobenen externen Vorrichtungstaktes, und zum Abstimmen bzw. Ausrichten (214, 216) der abgetasteten Daten auf das alternierende 1/0-Signalmuster (302);
eine Einrichtung zum Erzeugen einer Vielzahl von Phasen (222a, 222b, 222c, 222d) eines Kerntaktes;
eine Einrichtung zum Abtasten des alternierenden 1/0-Signalmusters (302) in einer Kerntaktdomäne (205) mit der Vielzahl von Phasen (222a, 222b, 222c, 222d);
eine Einrichtung (224) zum Auswählen der optimalen Abtastphase (308) für das Abtasten des alternierenden 1/0-Signalsmusters (302); und
eine Einrichtung zum Abtasten der abgestimmten bzw. ausgerichteten Daten (314, 316) mit der ausgewählten optimalen Abtastphase (308).

2. Netzwerkvorrichtung (100) nach Anspruch 1, wobei die Sendertaktdomäne des Weiteren eine Einrichtung zum Abtasten der Daten (204) mit der Ausgabe des Phasenverschiebungsgenerators umfasst, wobei die Daten (204) unter Verwendung von Flanken eines phasenverschobenen externen Vorrichtungstaktes (207) abgetastet werden, die von dem Phasenverschiebungsgenerator ausgegeben werden.

3. Netzwerkvorrichtung (100) nach Anspruch 2, wobei die Sendertaktdomäne des Weiteren eine Einrichtung zum Abstimmen bzw. Ausrichten von Daten (204), die bei den steigenden und fallenden Flanken des phasenverschobenen externen Vorrichtungstaktes (207) abgetastet werden, die von dem Phasenverschiebungsgenerator ausgegeben worden sind, auf das lokal erzeugte Signalmuster (302) umfasst.

4. Verfahren zum Ermitteln einer optimalen Abtastphase für mit einer Quelle synchrone Daten (204), die von einer externen Vorrichtung (201) gesendet werden, wobei das Verfahren die folgenden Schritte umfasst:
Empfangen, von einer Sendevorrichtung, in einer Sendertaktdomäne (203) eines Taktes (202) der externen Vorrichtung und von Daten (204) mit einer festen Phasenbeziehung;
Phasenverschieben des externen Vorrichtungstaktes (202, 206);
Erzeugen eines alternierenden 1/0-Signalmusters (302), welches bei jedem Taktzyklus alterniert, aus dem phasenverschobenen externen Vorrichtungstakt unter Verwendung einer Halbierschaltung;
Abtasten des Datensignals (304, 306) in der Sendertaktdomäne (203) unter Verwendung des phasenverschobenen externen Vorrichtungstaktes, und Abstimmen bzw. Ausrichten (214, 216) der abgetasteten Daten auf das alternierende 1/0-Signalmuster (302);
Erzeugen einer Vielzahl von Phasen (222a, 222b, 222c, 222d) eines Kerntaktes;
Abtasten des alternierenden 1/0-Signalmusters (302) in einer Kerntaktdomäne (205) mit der Vielzahl von Phasen (222a, 222b, 222c, 222d);
Auswählen der optimalen Abtastphase (308) für das Abtasten des alternierenden 1/0-Signalmusters (302); und
Abtasten der abgestimmten bzw. ausgerichteten Daten (314, 316) mit der ausgewählten optimalen Abtastphase (308).

5. Verfahren nach Anspruch 4, wobei der Schritt des Erstellens das Senden des externen Vorrichtungstaktes (202) zu einem Phasenverschiebungsgenerator und das Senden einer Ausgabe von dem Phasenverschiebungsgenerator zu einer Schaltung umfasst, die das lokal erzeugte Signalmuster (302) erstellt.

6. Verfahren nach Anspruch 5, das des Weiteren den Schritt des Abtastens der Daten (204) mit der Ausgabe des Phasenverschiebungsgenerators umfasst.

7. Verfahren nach Anspruch 6, das des Weiteren den Schritt des Abstimmens bzw. Ausrichtens von Daten (204), die unter Verwendung von Flanken der Ausgabe des Phasenverschiebungsgenerators abgetastet werden, auf das lokal erzeugte Signalmuster (302) umfasst.

## Revendications

1. Dispositif de réseau (100) pour déterminer une phase d'échantillonnage optimale pour des données synchrones de source (204) envoyées d'un dispositif externe (201), le dispositif de réseau (100) comprenant :
un moyen de réception pour recevoir d'un dispositif d'émission, dans un domaine d'horloge d'émetteur (203), une horloge de dispositif externe (202) et des données (204) avec une relation de phase fixe ;
un générateur de décalage de phase (206) pour décaler la phase de l'horloge de dispositif externe (202) ;
**caractérisé par**
un circuit de division par deux (208) pour recevoir l'horloge de dispositif externe à décalage de phase (207) et pour générer un motif de signal 1/0 en alternance (302), qui alterne à chaque cycle d'horloge ;
un moyen (210, 212) pour échantillonner le signal de données (304, 306) dans le domaine d'horloge d'émetteur (203) en utilisant ladite horloge de dispositif externe à décalage de phase, et pour aligner (214, 216) les données échantillonnées avec ledit motif de signal 1/0 en alternance (302) ;
un moyen pour générer une pluralité de phases (222a, 222b, 222c, 222d) d'une horloge de coeur ;
un moyen pour échantillonner le motif de signal 1/0 en alternance (302) dans un domaine d'horloge de coeur (205) avec la pluralité de phases (222a, 222b, 222c, 222d) ;
un moyen (224) pour sélectionner la phase d'échantillonnage optimale (308) pour échantillonner le motif de signal 1/0 en alternance (302) ; et
un moyen pour échantillonner les données alignées (314, 316) avec la phase d'échantillonnage optimale sélectionnée (308).

2. Dispositif de réseau (100) selon la revendication 1, dans lequel le domaine d'horloge d'émetteur comprend en outre un moyen pour échantillonner les données (204) avec la sortie du générateur de décalage de phase, dans lequel les données (204) sont échantillonnées en utilisant des fronts d'une horloge de dispositif externe à décalage de phase (207) délivrée par le générateur de décalage de phase.

3. Dispositif de réseau (100) selon la revendication 2, dans lequel le domaine d'horloge d'émetteur comprend en outre un moyen pour aligner des données (204) échantillonnées aux fronts montant et descendant de l'horloge de dispositif externe à décalage de phase (207) délivrée par le générateur de décalage de phase avec le motif de signal généré localement (302).

4. Procédé pour déterminer une phase d'échantillonnage optimale pour des données synchrones de source (204) envoyées d'un dispositif externe (201), le procédé comprenant les étapes consistant à :
recevoir d'un dispositif d'émission, dans un domaine d'horloge d'émetteur (203), une horloge de dispositif externe (202) et des données (204) avec une relation de phase fixe ;
décaler la phase de l'horloge de dispositif externe (202, 206) ;
générer un motif de signal 1/0 en alternance (302), qui alterne à chaque cycle d'horloge, à partir de l'horloge de dispositif externe à décalage de phase en utilisant un circuit de division par deux ;
échantillonner le signal de données (304, 306) dans le domaine d'horloge d'émetteur (203) en utilisant ladite horloge de dispositif externe à décalage de phase, et aligner (214, 216) les données échantillonnées avec ledit motif de signal 1/0 en alternance (302) ;
générer une pluralité de phases (222a, 222b, 222c, 222d) d'une horloge de coeur ;
échantillonner le motif de signal 1/0 en alternance (302) dans un domaine d'horloge de coeur (205) avec la pluralité de phases (222a, 222b, 222c, 222d) ;
sélectionner la phase d'échantillonnage optimale (308) pour échantillonner le motif de signal 1/0 en alternance (302) ; et
échantillonner les données alignées (314, 316) avec la phase d'échantillonnage optimale sélectionnée (308).

5. Procédé selon la revendication 4, dans lequel l'étape de création comprend la transmission de l'horloge de dispositif externe (202) à un générateur de décalage de phase et la transmission d'une sortie du générateur de décalage de phase à un circuit qui crée le motif de signal généré localement (302).

6. Procédé selon la revendication 5, comprenant en outre l'étape consistant à échantillonner les données (204) avec la sortie du générateur de décalage de phase.

7. Procédé selon la revendication 6, comprenant en outre l'étape consistant à aligner les données (204) échantillonnées en utilisant des fronts de la sortie du générateur de décalage de phase avec le motif de signal généré localement (302).
